# EUROPEAN PATENT APPLICATION

(11) **EP 4 297 064 A1**
(43) Date of publication of application: **27.12.2023**
(21) Application number: 22879857.5
(22) Date of filing: 31.05.2022

(54) **DISPLAY PANEL AND DISPLAY APPARATUS**

(30) Priority: 14.10.2021 CN 202111200056
(71) Applicant: Yungu (Gu'an) Technology Co., Ltd., Langfang, Hebei 065500 (CN)
(72) Inventor: ZHANG, Min, Langfang, Hebei 065500 (CN); ZHANG, Zhenyu, Langfang, Hebei 065500 (CN); LIU, Yawei, Langfang, Hebei 065500 (CN)
(74) Representative: Neusser, Sebastian
(86) International application number: PCT/CN2022/096479
(87) International publication number: WO 2023/060908

(57) **Abstract**

The present application discloses a display panel and a display apparatus. The display panel includes: a substrate; a light-emitting layer, located on one side of the substrate and including a plurality of light-emitting units arranged at intervals and a pixel definition block arranged between adjacent light-emitting units; and a low refractive index film layer and a high refractive index film layer which are arranged on the side of the light-emitting layer away from the substrate. The low refractive index film layer includes a plurality of microstructures, and the high refractive index film layer covers at least a part of surfaces of the microstructures. The orthographic projections of the microstructures on the light-emitting layer cover the light-emitting units in corresponding positions. In the thickness direction of the display panel, a plurality of total internal reflection interfaces are formed between the microstructures and the high refractive index film layer. In this way, the present application can reduce light emission at a large viewing angle from the display panel, thereby realizing privacy protection.

## Description

### TECHNICAL FIELD

The present application belongs to the technical field of displays, and in particular relates to a display panel and a display apparatus.

### BACKGROUND

The organic light-emitting diode (OLED) display panel is considered to be an emerging application technology for next-generation flat-panel displays due to its advantages such as self-illumination, high contrast, thinness, wide viewing angle, fast response, wide operating temperature range, simple structure and manufacture process.

At present, the OLED display panel is widely used in mobile phones. However, since more and more personal information is stored in the mobile phones, ensuring the confidentiality of personal information has become an important issue.

### SUMMARY

The present application provides a display panel and a display apparatus, which are capable of reducing light emission at a large viewing angle from the display panel and realizing privacy protection.

To solve the above technical issues, the present application provides a technical solution as follows. A display panel includes a substrate, a light-emitting layer, located on one side of the substrate, and including a plurality of light-emitting units arranged at intervals and a pixel definition block arranged between adjacent light-emitting units; and a low refractive index film layer and a high refractive index film layer which are arranged on a side of the light-emitting layer away from the substrate. The low refractive index film layer includes a plurality of microstructures, and at least a part of surfaces of the microstructures is covered by the high refractive index film layer. The orthographic projections of the microstructures on the light-emitting layer cover the light-emitting units in corresponding locations. A plurality of total internal reflection interfaces are formed between the microstructures and the high refractive index film layer in a thickness direction of the display panel.

To solve the above technical issues, the present application provides another technical solution as follows. A display apparatus includes the display panel described in any of the above embodiments.

Compared to the related art, the present application has the following beneficial effects. The display panel in the present application is provided with a low refractive index film layer and a high refractive index film layer which are arranged on the side of the light-emitting layer away from the substrate. The portion of the low refractive index film layer which corresponds to at least a part of the light-emitting units is provided with microstructures, and at least a part of the surfaces of the microstructures is covered by the high refractive index film layer. A plurality of total internal reflection interfaces are formed between the microstructures and the high refractive index film layer stacked in the thickness direction of the display panel. The light with a large viewing angle emitted by the light-emitting unit will be incident into the high refractive index film layer and will undergo total internal reflection after reaching the total internal reflection interface between the high refractive index film layer and the low refractive index film layer, so that the light with a large viewing angle is transformed into the light with a small viewing angle. Therefore, the intensity of the upright light emission from the display panel can be enhanced while the light emission at the large viewing angle can be reduced, and thus the privacy protection is achieved.

### BRIEF DESCRIPTION OF THE DRAWINGS

The below will briefly describe drawings to be used in the description of embodiments of the present application to more clearly illustrate the technical solutions in the embodiments. Obviously, the drawings in the following description are only some embodiments of the present application and other drawings can also be obtained by those of ordinary skill in the art based on these drawings without creative work, in which:
FIG. 1 is a structural schematic view of a display panel in an embodiment of the present application.
FIG. 2 is a structural schematic view of a display panel in another embodiment of the present application.
FIG. 3 is a structural schematic view of a display panel in another embodiment of the present application.
FIG. 4 is a structural schematic view of a display panel in another embodiment of the present application.
FIG. 5 is a schematic top view of an embodiment of a microstructure in the dotted box in FIG. 1.
FIG. 6 is a schematic top view of an embodiment of a microstructure and a light-emitting layer in the dotted box in FIG. 1.
FIG. 7 is a schematic top view of another embodiment of a microstructure and a light-emitting layer in the dotted box in FIG. 1.
FIG. 8 is a schematic top view of another embodiment of the microstructure and the light-emitting layer in the dotted box in FIG. 1.
FIG. 9 is a schematic top view of another embodiment of the microstructure and the light-emitting layer in the dotted box in FIG. 1.
FIG. 10 is a schematic top view of another embodiment of the microstructure and the light-emitting layer in the dotted box in FIG. 1.
FIG. 11 is a schematic top view of another embodiment of the microstructure and the light-emitting layer in the dotted box in FIG. 1.
FIG. 12 is a schematic top view of another embodiment of the microstructure and the light-emitting layer in the dotted box in FIG. 1.
FIG. 13 is a schematic top view of another embodiment of the microstructure and the light-emitting layer in the dotted box in FIG. 1.
FIG. 14 is a schematic top view of another embodiment of the microstructure and the light-emitting layer in the dotted box in FIG. 1.
FIG. 15 is a schematic top view of another embodiment of the microstructure and the light-emitting layer in the dotted box in FIG. 1.
FIG. 16 is a structural schematic view of a display apparatus in an embodiment of the present application.

### DETAILED DESCRIPTION

Hereinafter, the technical solutions in embodiments of the present application will be described clearly and completely with reference to the drawings in the embodiments of the present application. Apparently, the described embodiments are only some of the embodiments of the present application, but not all of them. Other embodiments obtained by those of ordinary skill in the art without making creative efforts based on the embodiments of the present application all belong to the scope of protection of the present application.

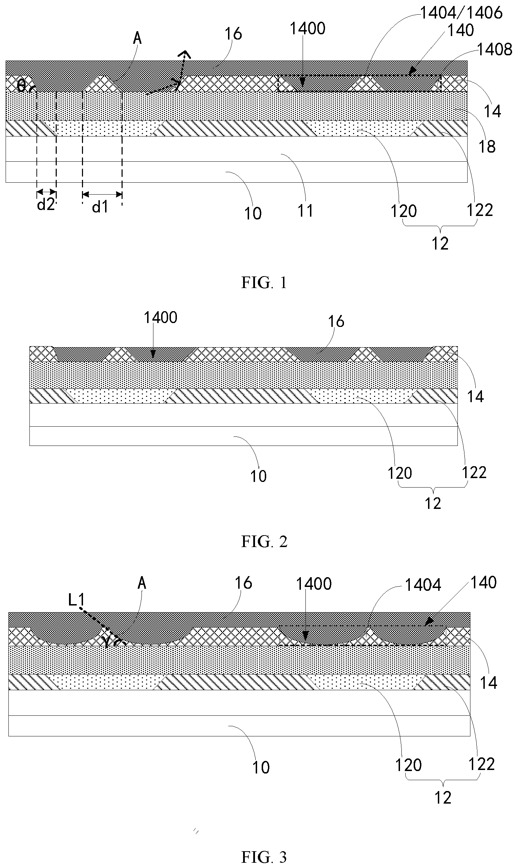

Referring to FIG. 1, FIG. 1 is a structural schematic view of a display panel in an embodiment of the present application. The display panel may be an OLED display panel or the like, which specifically includes: a substrate 10, a light-emitting layer 12, a low refractive index film layer 14, and a high refractive index film layer 16.

Specifically, the substrate 10 may be a flexible substrate such as polyimide or the like, or may be a rigid substrate such as glass or the like. The light-emitting layer 12 is located on a side of the substrate 10, and includes a plurality of light-emitting units 120 arranged at intervals and a pixel definition block 122 arranged between adjacent light-emitting units 120. The light-emitting unit 120 may be a red light-emitting unit, a green light-emitting unit, or a blue light-emitting unit, etc. The adjacent light-emitting units 120 may have same or different colors. The low refractive index film layer 14 and the high refractive index film layer 16 are arranged on the side of the light-emitting layer 12 away from the substrate 10. The specific relative positional relationship between the low refractive index film layer 14 and the high refractive index film layer 16 will be described in detail below. The low refractive index film layer 14 includes a plurality of microstructures 140, and at least a part of the surfaces of the microstructures 140 is covered by the high refractive index film layer 16. The microstructure 140 may have a size at a micron level or a nanometer level. The orthographic projection of each microstructure 140 on the light-emitting layer 12 covers a corresponding light-emitting unit 120. A plurality of total internal reflection interfaces A are formed between the microstructures 140 and the high refractive index film layer 16 in the thickness direction of the display panel. Optionally, in this embodiment, the refractive index of the low refractive index film layer 14 may be in a range from 1.38 to 1.7. The refractive index of the high refractive index film layer 16 may be in a range from 2 to 4. For example, the material of the low refractive index film layer 14 may be magnesium fluoride, etc. The material of the high refractive index film layer 16 may be titanium dioxide, etc.

The plurality of total internal reflection interfaces A can be formed between the microstructures 140 and the high refractive index film layer 16. As indicated by the dotted arrow in FIG. 1, the light with a large viewing angle emitted by the light-emitting unit 120 will be incident into the high refractive index film layer 16 and will undergo total internal reflection after reaching the total internal reflection interface A between the high refractive index film layer 16 and the low refractive index film layer 14, so that the light with a large viewing angle is transformed into the light with a small viewing angle. Therefore, the intensity of the upright light emission from the display panel can be enhanced while the light emission at the large viewing angle can be reduced, and thus the privacy protection is achieved.

Certainly, in other embodiments, the display panel provided in the present application may also include other structures. For example, an encapsulation layer 18 is located on the side of the light-emitting layer 12 away from the substrate 10. The low refractive index film layer 14 and the high refractive index film layer 16 are located on the side of the encapsulation layer 18 away from the substrate 10. Certainly, in some cases, in order to reduce the thickness of the display panel, the low refractive index film layer 14 and the high refractive index film layer 16 can directly replace the entire encapsulation layer 18, or replace certain layers in the encapsulation layer 18, which is not limited in this application. In addition, as shown in FIG. 1, an array layer 11 may be disposed between the substrate 10 and the light-emitting layer 12 and is configured to drive the light-emitting units 120 to emit light.

In one embodiment, as shown in FIG. 1, the microstructures 140 include a plurality of protrusions 1404 and a depression 1400 arranged between adjacent protrusions 1404. The depression 1400 penetrates the low refractive index film layer 14 in a stacking direction, i.e., in the thickness direction of the display panel. The low refractive index film layer 14 around the depression 1400 forms the protrusion 1404 in the microstructure 140. The high refractive index film layer 16 fills the depression 1400. The high refractive index film layer 16 and the low refractive index film layer 14 form the total internal reflection interfaces A at the sidewalls of the depression 1400. In this design mode, since the depression 1400 is arranged to penetrate the low refractive index film layer 14, fewer interfaces exist on the light propagation path of the light-emitting unit 120. As a result, there is less light loss and higher light emission intensity. In addition, in this embodiment, as shown in FIG. 1, the width of the depression 1400 increases at the side away from the light-emitting layer 12. This design mode is conducive to forming the total internal reflection interface A.

Further, referring to FIG. 1 again, in this embodiment, the low refractive index film layer 14 is stacked on the side of the light-emitting layer 12 away from the substrate 10. The high refractive index film layer 16 covers the surface of the low refractive index film layer 14 away from the substrate 10 and fills the depression 1400. In this design mode, the high refractive index film layer 16 is formed in a simple process and can be directly formed by coating, deposition or the like.

Alternatively, referring to FIG. 2, FIG. 2 is a structural schematic view of a display panel in another embodiment of the present application. The low refractive index film layer 14 is stacked on the side of the light-emitting layer 12 away from the substrate 10. The high refractive index film layer 16 only fills the depression 1400. The surface of the high refractive index film layer 16 away from the substrate 10 is flush with the surface of the low refractive index film layer 14 away from the substrate 10. Alternatively, the surface of the high refractive index film layer 16 away from the substrate 10 is slightly lower than the surface of the low refractive index film layer 14 away from the substrate 10. In this design mode, the amount of the used material of the high refractive index film layer 16 can be reduced, and thus the material cost is reduced and the thickness of the display panel is reduced.

Certainly, in other embodiments, the microstructures 140 in the above-mentioned low refractive index film layer 14 may have other design modes. For example, as shown in FIG. 3, FIG. 3 is a structural schematic view of a display panel in another embodiment of the present application. In the stacking direction, the low refractive index film layer 14 is provided with a plurality of non-penetrating depressions 1400. The bottom surface of the depression 1400 is an arc surface protruding toward the substrate 10. The low refractive index film layer 14 around the depression 1400 forms the protrusions 1404 in the microstructures 140. The high refractive index film layer 16 fills the depression 1400. The high refractive index film layer 16 and the low refractive index film layer 14 form the total internal reflection interfaces A at the sidewalls of the depression 1400. In this design mode, in addition to achieving the prevention of peeping, the bottom surface of the non-penetrating depression 1400 equivalently forms a spherical structure, which can concentrate the light emitted by the light-emitting unit 120 to enhance the intensity of the emitted light.

Further, referring to FIG. 3 again, in this embodiment, the low refractive index film layer 14 is stacked on the side of the light-emitting layer 12 away from the substrate 10. The high refractive index film layer 16 covers the surface of the low refractive index film layer 14 away from the substrate 10, and fills the depression 1400. In this design mode, the high refractive index film layer 16 is formed in a simple process and can be directly formed by coating, deposition or the like.

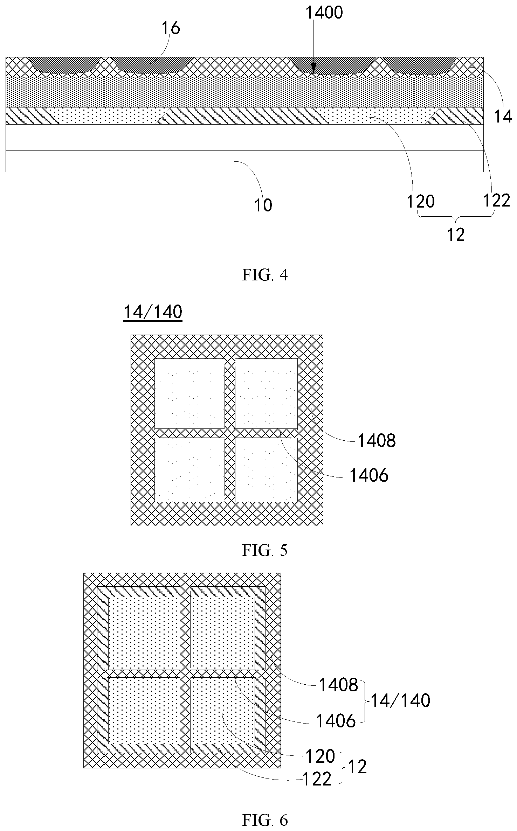

Alternatively, referring to FIG. 4, FIG. 4 is a structural schematic view of a display panel in another embodiment of the present application. The low refractive index film layer 14 is stacked on the side of the light-emitting layer 12 away from the substrate 10. The high refractive index film layer 16 only fills the depression 1400. The surface of the high refractive index film layer 16 away from the substrate 10 is flush with the surface of the low refractive index film layer 14 away from the substrate 10. Alternatively, the surface of the high refractive index film layer 16 away from the substrate 10 is slightly lower than the surface of the low refractive index film layer 14 away from the substrate 10. In this design mode, the amount of the used material of the high refractive index film layer 16 can be reduced, and thus the material cost is reduced and the thickness of the display panel is reduced.

In addition, referring to FIG. 1 again, the sidewalls of the depression 1400 are flat surfaces. The angle θ between the sidewalls of the depression 1400 and the horizontal direction perpendicular to the stacking direction is greater than or equal to the critical angle of total internal reflection and less than 90°. The critical angle of total internal reflection is arcsin(n2/n1), wherein n2 represents the refractive index of the high refractive index film layer 16, and n1 represents the refractive index of the low refractive index film layer 14. The above-mentioned design mode can achieve a better total internal reflection effect for the light with the large viewing angle. Certainly, in other embodiments, as shown in FIG. 3, the sidewalls of the depression 1400 may be an arc surface. The sidewalls of the depression 1400 include first tangent lines L1 which are tangent to the sidewalls. The angle γ between at least a part of the first tangent lines L1 and the horizontal direction perpendicular to the stacking direction is greater than or equal to the critical angle of total internal reflection and less than 90°.

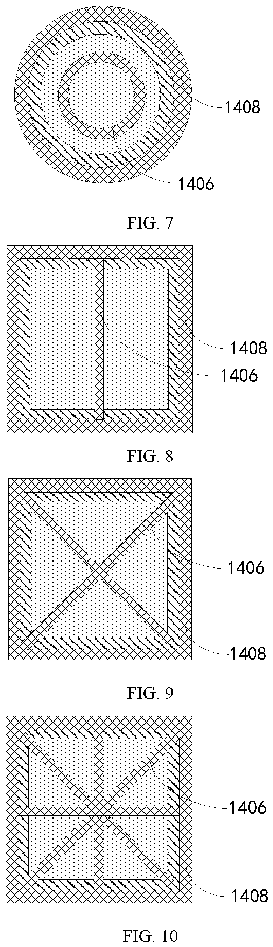

Referring to FIGs. 1, 5 and 6 together, FIG. 5 is a schematic top view of an embodiment of a microstructure in the dotted box in FIG. 1, and FIG. 6 is a schematic top view of an embodiment of a microstructure and a light-emitting layer in the dotted box in FIG. 1. The microstructure 140 in the low refractive index film layer 14 includes a first protrusion 1406 whose orthographic projection falls within an area of the light-emitting unit 120, and a second protrusion 1408 whose orthographic projection falls within an area of the pixel definition block 122. The second protrusion 1408 is arranged at the periphery of the first protrusion 1406 and to surround the first protrusion 1406. In this design mode, more total internal reflection interfaces A can be introduced into the microstructure 140 to enhance the anti-peeping performance. For example, in the direction perpendicular to the stacking direction, the outer walls of the first protrusion 1406 whose orthographic projection falls within the area of the light-emitting unit 120 can serve as the total internal reflection interfaces A. Also, the outer walls of the second protrusion 1408 facing the first protrusion 1406 can serve as the total internal reflection interfaces A. In addition, for a same microstructure 140, the shape of the second protrusion 1408 surrounding the first protrusion 1406 may be different from the shape of the first protrusion 1406. For example, as shown in FIG. 6, the orthographic projection of the second protrusion 1408 on the substrate 10 is a rectangular ring. The orthographic projection of the first protrusion 1406 on the substrate 10 is a strip structure. Alternatively, for a same microstructure 140, the shape of the second protrusion 1408 surrounding the first protrusion 1406 may be the same as the shape of the first protrusion 1406. For example, as shown in FIG. 7, FIG. 7 is a schematic top view of another embodiment of a microstructure and a light-emitting layer in the dotted box in FIG. 1. The orthographic projections of the first protrusion 1406 and the second protrusion 1408 on the substrate 10 are circular rings with different radii.

Optionally, in embodiments of the present application, as shown in FIG. 6, the orthographic projection of the first protrusion 1406 on the substrate 10 forms a straight line segment. Alternatively, as shown in FIG. 7, the orthographic projection of the first protrusion 1406 on the substrate 10 forms a curved line segment. Alternatively, the orthographic projection of the first protrusion 1406 on the substrate 10 forms a curved line segment and a straight line segment. Similarly, as shown in FIG. 6, the orthographic projection of the second protrusion 1408 on the substrate 10 forms a straight line segment. Alternatively, as shown in FIG. 7, the orthographic projection of the second protrusion 1408 on the substrate 10 forms a curved line segment. Alternatively, the orthographic projection of the second protrusion 1408 on the substrate 10 forms a straight line segment and a curved line segment. The above-mentioned first protrusion 1406 and the second protrusion 1408 have a relatively simple structural design, and can be formed through an easy manufacture process.

Optionally, the orthographic projection of the second protrusion 1408 on the substrate 10 includes a closed polygon as shown in FIG. 6 or a closed arc as shown in FIG. 7. The closed polygon may be a square as shown in FIG. 6, or a rectangle, a rhombus, a pentagon, an octagon, etc. The closed arc can be a circle, an ellipse, etc. Certainly, in other embodiments, the orthographic projection of the second protrusion 1408 on the substrate 10 has a closed shape formed by a straight line segment and an arc segment, for example, a racetrack shape. This design mode provides more total internal reflection interfaces A in the microstructure 140 to enhance the anti-peeping performance.

Optionally, the orthographic projection of the first protrusion 1406 on the substrate 10 includes at least one selected from a closed polygon, a closed arc as shown in FIG. 7, and a strip structure as shown in FIG. 6. The closed polygon may be a square, a rectangle, a rhombus, a pentagon, an octagon, etc. The closed arc may be a circle as shown in FIG. 7, or may be an ellipse. This design mode provides more total internal reflection interfaces A above the light-emitting unit 120 to enhance the anti-peeping performance.

In an application scenario, as shown in FIG. 8, FIG. 8 is a schematic top view of another embodiment of the microstructure and the light-emitting layer in the dotted box in FIG. 1. The orthographic projection of the first protrusion 1406 on the substrate 10 forms a strip structure. The number of the strip structure may be one. Optionally, when the orthographic projection of the second protrusion 1408 on the substrate 10 is a rectangle, the orthographic projection of the first protrusion 1406 on the substrate 10 (i.e., one strip structure) may be parallel to one side of the orthographic projection of the second protrusion 1408 on the substrate 10. Certainly, in other embodiments, the orthographic projection of the second protrusion 1408 on the substrate 10 may be a circle, an ellipse, etc.

In further another application scenario, as shown in FIG. 6, the orthographic projection of the first protrusion 1406 on the substrate 10 includes a plurality of strip structures. The number of the plurality of strip structures may be two, three, four, etc. However, when a plurality of strip structures exist, at least a part of the strip structures (i.e., the orthographic projection of the first protrusion 1406 on the substrate 10) may be arranged to intersect with each other. Optionally, all of the strip structures intersect to form an intersection point.

For example, as shown in FIG. 6, two first protrusions 1406 each with a strip shape are arranged to intersect at an angle of 90°. When the orthographic projection of the second protrusion 1408 on the substrate 10 is a rectangle, the orthographic projections of the two strip-shaped first protrusions 1406 may be respectively perpendicular to sides of the orthographic projection of the second protrusion 1408 on the substrate 10.

For another example, as shown in FIG. 9, FIG. 9 is a schematic top view of another embodiment of the microstructure and the light-emitting layer in the dotted box in FIG. 1. When the orthographic projection of the second protrusion 1408 on the substrate 10 is a rectangle, the orthographic projections of the two strip-shaped first protrusions 1406 on the substrate 10 may respectively be coincide with the diagonals of the orthographic projection of the second protrusion 1408 on the substrate 10.

For still another example, as shown in FIG. 10, FIG. 10 is a schematic top view of another embodiment of the microstructure and the light-emitting layer in the dotted box in FIG. 1. When the orthographic projection of the second protrusion 1408 on the substrate 10 is a rectangle, the orthographic projections of the four strip-shaped first protrusions 1406 on the substrate 10 intersect at one point. The orthographic projections of two of the four strip-shaped first protrusions 1406 on the substrate 10 may respectively be perpendicular to the sides of the orthographic projection of the second protrusion 1408 on the substrate 10. The orthographic projections of the other two strip-shaped first protrusions 1406 on the substrate 10 may respectively be coincide with the diagonals of the orthographic projection of the second protrusion 1408 on the substrate 10.

In yet another application scenario, the orthographic projection of the first protrusion 1406 on the substrate 10 includes a strip structure, and specifically may include a plurality of strip structures, such as two, three, four or more of strip structures. When there are a plurality of strip structures, at least a part of the strip structures can be arranged to intersect with each other. Optionally, the plurality of strip structures intersect to form a plurality of intersection points.

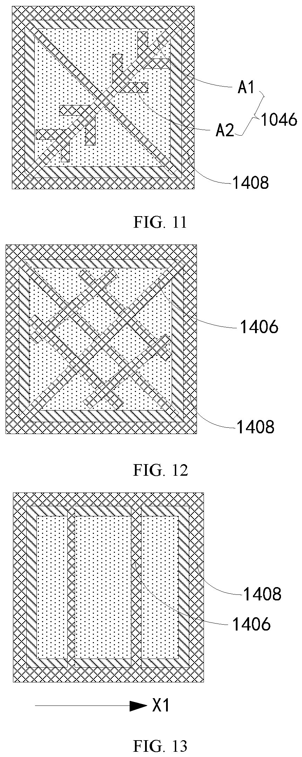

For example, the number of the intersection points formed by the plurality of strip structures may be less than or equal to the number of strip structures. As shown in FIG. 11, FIG. 11 is a schematic top view of another embodiment of the microstructure and the light-emitting layer in the dotted box in FIG. 1. The plurality of strip structures include first strip structures A1 each with a larger size and intersected with each other, only two of which are schematically shown in FIG. 11, and include second strip structures A2 each with a smaller size, only eight of which are schematically shown in FIG. 11. That is, the length of the first strip structure A1 is greater than the length of the second strip structure A2. As shown in FIG. 11, the two first strip structures A1 may intersect at one point. Among the eight second strip structures A2, every two second strip structures A2 may intersect at one intersection point. The intersection point is located on the first strip structure A1. In this case, the plurality of second strip structures A2 are connected to the first strip structure A1. The first strip structure A1 and the second strip structures A2 connected thereto form a fishbone shape.

For still another example, the number of intersection points formed by the plurality of strip structures may be greater than the number of strip structures. As shown in FIG. 12, FIG. 12 is a schematic top view of another embodiment of the microstructure and the light-emitting layer in the dotted box in FIG. 1. In this case, a plurality of strip structures intersect to form a network.

In yet still another application scenario, the orthographic projection of the first protrusion 1406 on the substrate 10 includes a strip structure, and specifically may include a plurality of strip structures, such as two, three, four or more strip structures. When there are a plurality of strip structures, the plurality of strip structures may be arranged parallel to each other.

For example, as shown in FIG. 13, FIG. 13 is a schematic top view of another embodiment of the microstructure and the light-emitting layer in the dotted box in FIG. 1. In a direction perpendicular to the length extension direction of the strip structure (i.e., the direction marked as X1 in FIG. 13), a plurality of strip structures are arranged at intervals and parallel to each other. The adjacent strip structures are spaced from each other. For example, when the orthographic projection of the second protrusion 1408 on the substrate 10 is a rectangle, the orthographic projections of the plurality of strip-shaped first protrusions 1406 on the substrate 10 may be parallel to a side of the orthographic projection of the second protrusion 1408 on the substrate 10.

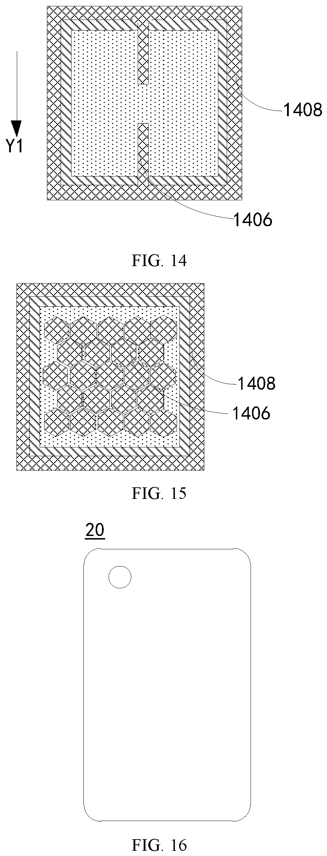

For another example, as shown in FIG. 14, FIG. 14 is a schematic top view of another embodiment of the microstructure and the light-emitting layer in the dotted box in FIG. 1. The length extension direction Y1 of the plurality of strip structures is located in a same straight line. In this case, the plurality of strip structures located in the same straight line can be arranged at intervals. That is, the adjacent strip structures among the plurality of strip structures are spaced from each other.

In yet another application scenario, as shown in FIG. 15, FIG. 15 is a schematic top view of another embodiment of the microstructure and the light-emitting layer in the dotted box in FIG. 1. The orthographic projections of the first protrusions 1406 on the substrate 10 include a plurality of closed polygons such as hexagons in FIG. 15, pentagons or quadrangles, or a plurality of closed arcs such as circles, ellipse, etc. The plurality of closed polygons or the plurality of closed arcs form a structure similar to a moth-eye structure as shown in FIG. 15. Correspondingly, in this case, the first protrusions 1406 may be prisms, pyramids, circular truncated cones, or cylinders.

In the above application scenarios, only a few of structural design modes of the first protrusion 1406 and the second protrusion 1408 are illustrated. In the above application scenarios, more total internal reflection interfaces A can be introduced into the microstructure 140, to enhance anti-peeping performance.

In addition, referring to FIG. 1 again, the maximum width d1 of the vertical cross section of the first protrusion 1406 in a stacking direction is greater than or equal to 0.5 microns and less than or equal to 5 microns. For example, d1 is 1 micron, 2 microns, 3 microns, 4 microns, etc. Alternatively, the distance d2 in the stacking direction between the edge at a side adjacent to the substrate 10 of the second protrusion 1408 and the edge at a side adjacent to the substrate 10 of the pixel definition block 122 corresponding to the second protrusion 1408 is greater than or equal to 0.5 microns and less than or equal to 5 microns. For example, d2 is 1 micron, 2 microns, 3 microns, 4 microns, etc. The arrangement of the above-mentioned maximum width d1 and distance d2 can ensure a relatively high light output efficiency.

Referring to FIG. 16, FIG. 16 is a structural schematic view of a display apparatus in an embodiment of the present application. The display apparatus may be a mobile phone, etc., and may include the display panel in any of the above-mentioned embodiments.

The above descriptions are only embodiments of the present application, and do not limit the scope of the present application. Any equivalent structure or equivalent flow transformation made by using the specification and drawings of the present application, or directly or indirectly used in other related technical fields, are all included in the scope of protection of this application in the same manner.

## Claims

1. A display panel, comprising:
a substrate,
a light-emitting layer, located on one side of the substrate, and comprising a plurality of light-emitting units arranged at intervals and a pixel definition block arranged between adjacent light-emitting units,
a low refractive index film layer and a high refractive index film layer, arranged on a side of the light-emitting layer away from the substrate;
wherein the low refractive index film layer comprises a plurality of microstructures, and at least a part of surfaces of the microstructures is covered by the high refractive index film layer;
orthographic projections of the microstructures on the light-emitting layer cover the light-emitting units in corresponding locations; and
a plurality of total internal reflection interfaces are formed between the microstructures and the high refractive index film layer in a thickness direction of the display panel.

2. The display panel according to claim 1, wherein each of the microstructures comprises a first protrusion whose orthographic projection falls within an area of one light-emitting unit, and a second protrusion whose orthographic projection falls within an area of the pixel definition block, and
the second protrusion is arranged at a periphery of the first protrusion and surrounds the first protrusion.

3. The display panel according to claim 2, wherein the orthographic projections of the first protrusion and the second protrusion on the substrate include a straight line segment and/or a curved line segment.

4. The display panel according to claim 3, wherein the orthographic projection of the second protrusion on the substrate comprises one closed polygon or one closed arc; and/or
the orthographic projection of the first protrusion on the substrate comprises at least one selected from a closed polygon, a closed arc, and a strip structure.

5. The display panel according to claim 3, wherein the orthographic projection of the first protrusion on the substrate comprises one or a plurality of strip structures, and the plurality of the strip structures are arranged parallel to each other.

6. The display panel according to claim 5, wherein a length extension direction of the plurality of strip structures is located in a same straight line.

7. The display panel according to claim 5, wherein the plurality of strip structures are arranged at intervals in a direction perpendicular to a length extension direction of the strip structures.

8. The display panel according to claim 3, wherein the orthographic projection of the first protrusion on the substrate comprises a plurality of strip structures, and at least a part of the plurality of strip structures are arranged to intersect with each other.

9. The display panel according to claim 8, wherein the plurality of strip structures intersect to form an intersection point.

10. The display panel according to claim 8, wherein the plurality of strip structures intersect to form a plurality of intersection points, and the number of the intersection points is greater than the number of the strip structures.

11. The display panel according to claim 3, wherein the orthographic projection of the first protrusion on the substrate comprises a plurality of closed polygons or a plurality of closed arcs, and the plurality of closed polygons or the plurality of closed arcs form a moth-eye structure.

12. The display panel according to claim 2, wherein the maximum width of a vertical cross section of the first protrusion in a stacking direction is greater than or equal to 0.5 microns and less than or equal to 5 microns.

13. The display panel according to claim 2, wherein a distance in a stacking direction between an edge at a side adjacent to the substrate of the second protrusion and an edge at a side adjacent to the substrate of the pixel definition block corresponding to the second protrusion is greater than or equal to 0.5 microns and less than or equal to 5 microns.

14. The display panel according to claim 1, wherein the microstructures comprise a plurality of protrusions and a depression between adjacent protrusions,
the depression penetrates the low refractive index film layer in a stacking direction, and
the low refractive index film layer around the depression is the protrusions in the microstructures;
wherein the high refractive index film layer fills the depression, and the high refractive index film layer and the low refractive index film layer form the total internal reflection interfaces at sidewalls of the depression.

15. The display panel according to claim 1, wherein the microstructures comprise a plurality of protrusions and a depression between adjacent protrusions,
the depression does not penetrate the low refractive index film layer in a stacking direction, and
a bottom surface of the depression is an arc surface protruding toward the substrate,
the low refractive index film layer around the depression is the protrusions in the microstructures;
wherein the high refractive index film layer fills the depression, and the high refractive index film layer and the low refractive index film layer form the total internal reflection interfaces at sidewalls of the depression.

16. The display panel according to claim 14, wherein the low refractive index film layer is stacked on one side of the light-emitting layer away from the substrate;
the high refractive index film layer covers a surface of the low refractive index film layer away from the substrate and fills the depression; or
the high refractive index film layer is flush with the low refractive index film layer and only fills the depression.

17. The display panel according to claim 15, wherein the low refractive index film layer is stacked on one side of the light-emitting layer away from the substrate;
the high refractive index film layer covers a surface of the low refractive index film layer away from the substrate and fills the depression; or
the high refractive index film layer is flush with the low refractive index film layer and only fills the depression.

18. The display panel according to claim 14, wherein the sidewalls of the depression are flat surfaces, and an angle between the sidewalls of the depression and a horizontal direction perpendicular to the stacking direction is greater than or equal to a critical angle of total internal reflection and less than 90°; or
the sidewalls of the depression are arc surfaces, the sidewalls of the depression comprise first tangent lines tangent to the sidewalls, and an angle between at least a part of the first tangent lines and a horizontal direction perpendicular to the stacking direction is greater than or equal to a critical angle of total internal reflection and less than 90°.

19. The display panel according to claim 15, wherein the sidewalls of the depression are flat surfaces, and an angle between the sidewalls of the depression and a horizontal direction perpendicular to the stacking direction is greater than or equal to a critical angle of total internal reflection and less than 90°; or
the sidewalls of the depression are arc surfaces, the sidewalls of the depression comprise first tangent lines tangent to the sidewalls, and an angle between at least a part of the first tangent lines and a horizontal direction perpendicular to the stacking direction is greater than or equal to a critical angle of total internal reflection and less than 90°.

20. A display apparatus comprising the display panel according to any one of claims 1 to 19.
